# EUROPÄISCHE PATENTSCHRIFT

(11) **EP 1 399 968 B1**
(45) Veröffentlichungstag und Bekanntmachung des Hinweises auf die Patenterteilung: **28.11.2012**
(21) Anmeldenummer: 02712785.1
(22) Anmeldetag: 15.02.2002
(51) Int. Cl.: H01L 27/02

(54) **THYRISTORSTRUKTUR UND ÜBERSPANNUNGSSCHUTZANORDNUNG MIT EINER SOLCHEN THYRISTORSTRUKTUR**
THYRISTOR CONFIGURATION AND SURGE SUPPRESSOR COMPRISING A THYRISTOR CONFIGURATION OF THIS TYPE
STRUCTURE DE THYRISTOR ET DISPOSITIF COUPE-CIRCUIT DE SURTENSION COMPORTANT UNE TELLE STRUCTURE DE THYRISTOR

(30) Priorität: 09.03.2001 DE 10111462
(43) Veröffentlichungstag der Anmeldung: 24.03.2004
(73) Patentinhaber: Infineon Technologies AG, 85579 Neubiberg (DE)
(72) Erfinder: PETERS, Christian, 85591 Vaterstetten (DE)
(74) Vertreter: Viering, Jentschura & Partner
(86) Internationale Anmeldenummer: PCT/DE2002/000547
(87) Internationale Veröffentlichungsnummer: WO 2002/073695

(56) Entgegenhaltungen:
- EP-A- 1 045 444
- EP-A- 1 058 308
- WO-A-00/08688
- WO-A1-01/11684
- WO-A1-89/06047
- US-A- 5 907 462
- US-A- 6 081 002

## Beschreibung

Die Erfindung betrifft eine Thyristorstruktur und eine Überspannungsschutzanordnung gemäß der Patentansprüche 1 und 3.

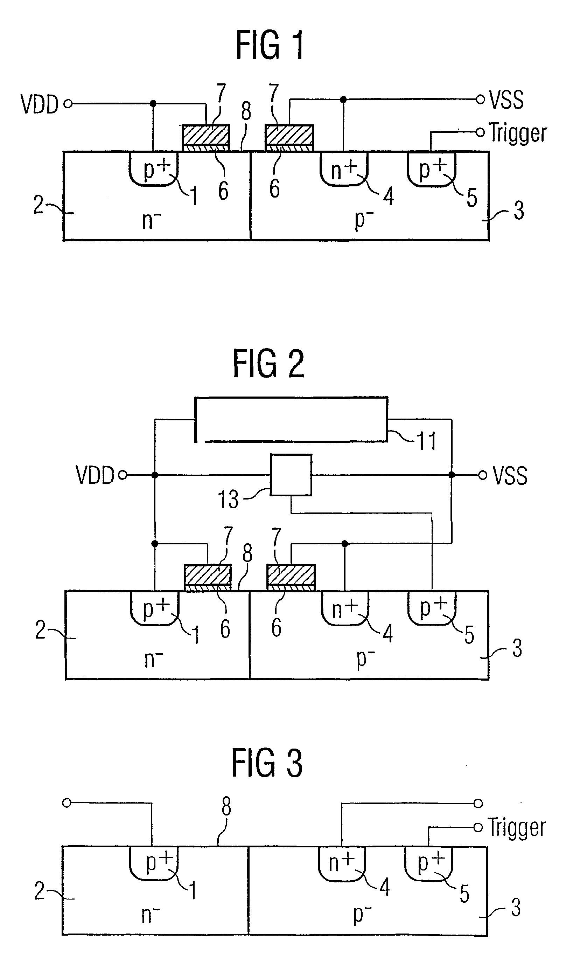

Heutzutage sind bei Verwendung von CMOS-Technologien Thyristorstrukturen üblich, die eine planare Strukur aufweisen. Eine derartige Thyristorstruktur ist prinzipiell in Fig. 3. An der Oberfläche eines solchen Bauelementes sind nebeneinanderliegend ein n⁻-Gebiet 2 und ein p⁻-Gebiet 3 angeordnet, die die auch so genannten Basisgebiete der Thyristorstruktur bilden. Im n⁻-Gebiet 2 ist ein p⁺-Gebiet 1 ausgebildet, das den Anodenanschluß darstellt. Den Kathodenanschluß stellt ein im p⁻-Gebiet 3 ausgebildetes n⁺-Gebiet 4 dar. Den Steueranschluß wiederum bildet ein im p⁻-Gebiet 3 ausgebildetes p⁺-Gebiet 5.

Bei der Herstellung der zuvor beschriebenen Struktur wird an der Oberfläche 8 ein Nitridschicht aufgetragen. Ladungen in dieser Nitridschicht führen zu einem parasitären Feldeffekt. Der gleiche parasitäre Effekt tritt auf, wenn an der Oberfläche 8 Verunreinigungen in den Gebieten 2 und 3 bei der Herstellung eingebaut werden.

Besonders häufig findet die zuvor beschriebene Thyristorstrukt ihre Anwendung in Überspannungsschutzanordnungen einem so genannten ESD-Schutz. Dieser findet häufig bei MOS-Eingangsstufen von integrierten Schaltungen Anwendung. Am zu schützenden Teil der integrierten Schaltung wird ein Überspannungsdetektor angeordnet, der mit dem Steueranschluß des Thyristors verbunden ist. Eine derartige Anordnung ist in US 4,896,243 beschrieben.

Anode und Kathode des Thyristors sind wiederum mit der Versorgungspannung des zu schützenden Bauelementes verbunden, wenn die Versorgungspannung überwacht werden soll.

Tritt nunmehr eine Überspannung auf, so wird der Thyristor über den Steueranschluß eingeschaltet und die Überspannung abgeleitet.

Ist nunmehr der parasitäre Feldeffekttransistor, wie zuvor beschrieben ausgebildet, so wird die überwachte Spannung kurzgeschlossen, was zum Gesamtausfall des zu schützenden Bauelementes führt.

Aus der US 5,907,462 EP 1 045 444 und der US 5,465,189 sind ESD-Strukturen bekannt, die mittels einer Feldeffektstruktur gesteuert werden.

Aus der US 5,907,462 ist eine Thyristorstruktur mit einem ersten und einem zweiten Anschluss bekannt, die jeweils an ein zweites und drittes Gebiet angrenzen. Es ist eine Elektrode (116) vorgesehen, die einstückig über beide Basisgebiete, die durch das zweite und dritte Gebiet gebildet sind, hinweg gezogen ist. Diese Elektrode dient dazu, den Transistor 120 bei Auftreten einer Spannung am Anschluß (128) leitend zu steuern.

Der Erfindung liegt die Aufgabe zugrunde eine Thyristorstruktur bzw. eine Überspannungsschutzanordnung mit einer derartigen Thyristorstruktur derart weiterzubilden, daß der Einfluß parasitärer Effekte vermieden wird.

Diese Aufgabe wird erfindunggemäß mit den in den nebengeordneten Patentansprüchen angegebenen Maßnahmen gelöst.

Durch das Ausbilden zumindest einer Hilfs-Elektrode an der Oberfläche einer der beiden Gebiete des zweiten und dritten Gebietes, ist es möglich, die Oberfläche im Bereich der Hilfs-Elektrode in einen vorbestimmten Ladungszustand zu versetzen.

Eine Überspannungsschutzanordnung mit einer derartigen Thyristorstruktur führt nicht zum Ausfall des zu schützenden Bauteils durch parasitäre Effekte.

Durch das vorsehen jeweils einer Hilfs-Elektrode auf dem zweiten und dritten Gebiet und dem Verbinden der Hilfs-Elektroden auf dem zweiten Gebiet mit dem ersten Anschluß und der Hilfs-Elektrode am dritten Gebiet mit dem zweiten Anschluß, können auf einfache Weise an der Oberfläche die vorgegebenen Ladungszustände erzeugt werden.

Durch das Ausbilden der Hilfs-Elektrode mit Polysilizium und einem dieses von dem zweiten und dritten Gebiet trennenden Gateoxids, ist die Hilfs-Elektrode in einer üblichen Technologie einfach herstellbar.

Durch das integrieren der Überspannungsschutzanordnung auf einem Halbleiterschip ist der Überspannungsschutz einfach und wirkungsvoll herstellbar.

Nachfolgend wird die Erfindung unter Bezugnahme auf die Zeichnung an Hand von Ausführungsbeispielen erläutert.

Es zeigen:
Fig. 1 eine erfindungsgemäße Thyristorstruktur,
Fig. 2 eine erfindungsgemäße Überspannungsschutzanordnung in prizipieller Darstellung,und
Fig. 3 eine übliche Thyristorstrukur.

Fig. 1 zeigt ein erfindungsgemäßes Ausführungsbeispiel einer Thyristorstruktur, die grundsätzlich der entspricht, die unter Bezugnahme auf Fig. 3 bereits in der Beschreibungseinleitung erläutert wurde. Gleiche Teile sind dabei mit gleichen Bezugszeichen versehen.

Zusätzlich ist bei dem dargestellten Ausführaungsbeispiel an der gemeinsamen Oberfläche vom zweiten Gebiet 2 und dritten Gebiet 3, die häufig auch als Basisgebiete des Thyristors bezeichnet sind, voneinander getrennte Hilfs-Elektroden ausgebildet. Diese Hilfs-Elektroden setzen sich aus einem für die Herstellung von Feldeffektransistoren üblichen Gateoxid 6 und einem Elektrodenkontakt 7 aus Polysilizium zusammen. Der Elektrodenkontakt 7 der Hilfs-Elektrode, die an der Oberfläche des zweiten Gebietes 2 ausgebildet ist, ist elektrisch leitend mit dem ersten Anschluß 1, dem Anodenkontakt verbunden. Die Hilfs-Elektrode, die an dem dritten Gebiet 3 ausgebildet ist, ist mit dem zweiten Anschluß, dem Kathodenkontakt elektrisch leitend verbunden. Auf diese Weise ist sichergestellt, daß sich an der Oberfläche in den Basisgebieten durch parasitäre Effekte kein leitender Kanal ausbilden kann, der einen Kurzschluß zwischen erstem Anschluß 1 und zweitem Anschluß 3 bewirken würde. Eine Aufsteuerung der Thyristorstruktur erfolgt nur durch das Einprägen eines Stroms am Steueranschluß 5.

Fig. 3 zeigt in prizipieller Darstellung die Thyristorstruktur in einer Überspannungsanordnung. Die zuvor beschriebene Thyristorstruktur ist mit ihrem Anoden- bzw. Kathodenanschluß, d.h. mit dem ersten Anschluß 1 und dem zweiten Anschluß 3, mit der Versorgungspannung VDD und VSS des zu schützenden Bauelements 11 verbunden. Eine Überspannungsdetektoreinrichtung 13 überwacht einen die Versorgungsspannung des zu schützenden Bauelements 11. Beim Auftreten einer Überspannung prägt die Überspannungsdetektoreinrichtung 13 einen Strom über den Steueranschluß 5 in ein Basisgebiet, nämlich dem dritten Gebiet 3, der Thyristorstruktur ein. Diese zündet und schließt die Versorgungsspannung kurz.

Die Anordnung ist besonders für eine Integration geeignet. Dies bedeutet, die Thyristorstruktur wird zusammen mit dem Überspannungsdetektor an der Oberfläche des zu schützenden Bauelements integriert, wobei durch die beiden Hilfs-Elektroden vermieden wird, daß die Thyristorstruktur unter einem Dickoxid angeordnet wird, um parasitäre Effekte zu vermeiden. Somit bleibt die Wirkung der Thyristorstruktur vollständig erhalten.

Weiterhin ist eine solche Anordnung auf andere Spannungsüberwachungen, wie die Spannung von Signaleingängen anwendbar.

## Patentansprüche

1. Thyristorstruktur mit
- einem ersten Anschluss (1), der als erstes Gebiet mit einem ersten Leitfähigkeitstyp ausgebildet ist,
- einem zweiten Gebiet (2) eines zweiten Leitfähigkeitstyps, das an das erste Gebiet (1) angrenzt,
- einem dritten Gebiet (3) vom ersten Leitfähigkeitstyp, das an das zweite Gebiet (2) angrenzt und mit diesem eine gemeinsame Oberfläche (8) aufweist, und
- einem zweiten Anschluss (4), das als viertes Gebiet vom zweiten Leitfähigkeitstyp an das dritte Gebiet angrenzt,
- wobei an der gemeinsamen Oberfläche von dem zweiten Gebiet (2) und dem dritten Gebiet (3) an jedes der beiden Gebiete angrenzend jeweils eine durch eine Isolationsschicht (6) getrennte Hilfs-Elektrode (6, 7) angeordnet ist, wobei die beiden Hilfs-Elektroden (6, 7) voneinander getrennt angeordnet sind, **dadurch gekennzeichnet, dass** der Teil des zweiten Gebiets (2), der lateral zwischen den Hilfs-Elektroden (6, 7) angeordnet ist, freei von Gebieten des ersten Leitfähigkeitstyps ist und der Teil des dritten Gebiets (3), der lateral zwischen den Hilfs-Elektroden (6, 7) angeordnet ist, frei von Gebieten des zweiten Leitfähigkeitstyps ist.

2. Thyristorstruktur nach Anspruch 1, **dadurch gekennzeichnet, dass** die Hilfs-Elektrode (6, 7) aus einem leitfähigen Bereich (7) aus Polysilizium und einem den leitfähigen Bereich (7) von der gemeinsamen Oberfläche (8) isolierenden Gateoxid (6) gebildet ist.

3. Überspannungsschutzanordnung mit einer Thyristorstruktur nach einem der Ansprüche 1 oder 2, bei der ein zu schützendes Bauelement (11) zwischen dem ersten Anschluss (1) und dem zweiten Anschluss (4) elektrisch leitend angeordnet ist und das zweite oder dritte Gebiet (3) einen Steueranschluss (5) aufweist, an dem ein Überspannungsdetektor angeschlossen ist, der eine Überspannung an dem zu schützenden Bauelement erfasst.

4. Überspannungsschutzanordnung nach Anspruch 3, **dadurch gekennzeichnet, dass** der Steueranschluss (5) ein Gebiet vom gleichen Leitfähigkeitstyp wie das Gebiet, an dem es angeordnet ist, ist und eine höhere Leitfähigkeit als dieses aufweist.

5. Überspannungsschutzanordnug nach Anspruch 3 oder 4, **dadurch gekennzeichnet, dass** an den ersten Anschluss (1) und den zweiten Anschluss (4) die Versorgungsspannung (VDD, VSS) des zu schützenden Bauelements angeschlossen ist.

6. Überspannungsschutzanordnung nach Anspruch 3, 4 oder 5, **dadurch gekennzeichnet, dass** die Überspannungsschutzanordnung integriert auf einem einzigen Halbleiterchip angeordnet ist.

## Claims

1. Thyristor structure, comprising:
• a first terminal (1) formed as a first region having a first conductivity type,
• a second region (2) of a second conductivity type adjoining the first region (1),
• a third region (3) of the first conductivity type adjoining the second region (2) and having a common surface (8) therewith, and
• a second terminal (4) adjoining the third region as a fourth region of the second conductivity type,
• wherein on the common surface of the second region (2) and the third region (3) adjoining each of the both regions respectively one auxiliary electrode (6, 7) separated by an isolating layer (6) is arranged, wherein the both auxiliary electrodes (6, 7) are arranged separated from each other,
**characterized in that**
the portion of the second region (2) arranged laterally between the auxiliary electrodes (6, 7) are free of regions of the first conductivity type and the portion of the third region (3) arranged laterally between the auxiliary electrodes (6, 7) are free of regions of the second conductivity type.

2. Thyristor structure according to claim I,
**characterized in that**
the auxiliary electrode (6, 7) is formed by a conductive region (7) made of polysilicon and a gate oxide (6) insulating the conductive region (7) from the common surface (8).

3. Surge suppressor arrangement with a thyristor structure according to claim 1 or claim 2, wherein a component to be protected (11) is electrically conductively arranged between the first terminal (1) and the second terminal (4), and the second or the third region (3) comprises a control terminal (5) having an overvoltage detector connected thereto, which detects an overvoltage at the component to be protected.

4. Surge suppressor arrangement according to claim 3, **characterized in that** the control terminal (5) is a region of the same conductivity type as the region, at which it is arranged, and has a higher conductivity than the same.

5. Surge suppressor arrangement according to claim 3 or 4, **characterized in that** the supply voltage (VDD, VSS) of the component to be protected is connected to the first terminal (1) and to the second terminal (4).

6. Surge suppressor arrangement according to claim 3, 4 or 5, **characterized in that** the overvoltage protection configuration is arranged integrated on a single semiconductor chip.

## Revendications

1. Structure de thyristor comprenant
- une première borne (1) qui est constituée sous la forme d'une première région ayant un premier type de conductivité,
- une deuxième région (2) d'un deuxième type de conductivité, qui est voisine de la première région (1),
- une troisième région (3) du premier type de conductivité, qui est voisine de la deuxième région (2) et qui a avec elle une surface (8) commune et
- une deuxième borne (4) qui, en tant que quatrième région du deuxième type de conductivité, est voisine de la troisième région,
- dans laquelle
- respectivement une électrode (6, 7) auxiliaire séparée par une couche (6) isolante est montée sur la surface commune de la deuxième région (2) et de la troisième région (3) au voisinage de chacune des deux régions, les deux électrodes (6, 7) auxiliaires étant montées séparément l'une de l'autre, **caractérisée en ce que** la partie de la deuxième région (2), qui est montée latéralement entre les électrodes (6, 7) auxiliaires, est exempte de région du premier type de conductivité et la partie de la troisième région (3), qui est montée latéralement entre les électrodes (6, 7) auxiliaires, est exempte de région du deuxième type de conductivité.

2. Structure de thyristor suivant la revendication 1, **caractérisée en ce que** les électrodes (6, 7) auxiliaires sont formées d'une zone (7) conductrice en polysilicium et d'un oxyde (6) de grille isolant la zone (7) conductrice de la surface (8) commune.

3. Montage de protection vis-à-vis de la surtension comprenant une structure de thyristor suivant l'une des revendications 1 ou 2, dans lequel un composant (11) à protéger est monté d'une manière conductrice de l'électricité entre la première borne (1) et la deuxième borne (4) et la deuxième ou la troisième région (3) a une borne (5) de commande, à laquelle est raccordé un détecteur de surtension, qui détecte une surtension sur le composant à protéger.

4. Montage de protection vis-à-vis de la surtension suivant la revendication 3, **caractérisé en ce que** la borne (5) de commande a une région du même type de conductivité que la région où elle est montée et une conductivité plus grande que celle-ci.

5. Montage de protection vis-à-vis de la surtension suivant la revendication 3 ou 4, **caractérisé en ce que** la tension (VDD, VSS) d'alimentation du composant à protéger est appliquée à la première borne (1) et à la deuxième borne (4).

6. Montage de protection vis-à-vis de la surtension suivant la revendication 3, 4 ou 5, **caractérisé en ce que** le montage de protection vis-à-vis de la surtension est intégré à une unique puce à semi-conducteur.
